# EUROPEAN PATENT APPLICATION

(11) **EP 2 881 251 A1**
(43) Date of publication of application: **10.06.2015**
(21) Application number: 13822777.2
(22) Date of filing: 22.07.2013
(51) Int. Cl.: B32B 27/00, B32B 27/30, H01L 31/042, B29C 47/06, B29K 27/12, B29K 71/00

(54) **MULTILAYER SHEET, BACKSHEET FOR SOLAR CELL AND SOLAR CELL MODULE**

(30) Priority: 23.07.2012 JP 2012162526
(71) Applicant: Denki Kagaku Kogyo Kabushiki Kaisha, Tokyo 103-8338 (JP)
(72) Inventor: MIYAMURA Yasushi, Isesaki-city Gunma 372-0855 (JP); SAITO Tomoo, Isesaki-city Gunma 372-0855 (JP); NAKAJIMA Koji, Isesaki-city Gunma 372-0855 (JP)
(74) Representative: Turner, James Arthur
(86) International application number: PCT/JP2013/069825
(87) International publication number: WO 2014/017446

(57) **Abstract**

Provided are a multilayer sheet, a backsheet for solar cell, and a solar cell module superior in weather resistance, heat resistance, moisture resistance, flame resistance, and also interlayer adhesion.

A multilayer sheet 10, comprising a first resin layer 1 of a polyphenylene ether-containing resin composition, a second resin layer 2 of a polyvinylidene fluoride-based resin composition, and an adhesion resin layer 3, which is placed between the first and second resin layers, of one or more resins selected from acrylic resins and polymers having a structural unit derived from conjugated diene, wherein the adhesion resin layer 3 is fused both to the first and second resin layers 1 and 2. In addition, a backsheet comprising the multilayer sheet 10 is placed on and bonded to the non-light-receiving surface of a solar cell module, to give a solar cell module.

## Description

### Technical Field

The present invention relates to a multilayer sheet and also a back sheet for solar cells and a solar cell module prepared by using the multilayer sheet. More specifically, it relates to a multilayer sheet having a polyvinylidene fluoride-based resin layer and also a back sheet for solar cells and a solar cell module prepared by using the same.

### Background Art

As solar cell modules are used outdoors for an extended period of time, for assurance of mechanical strength and prevention of degradation under the environment atmosphere, generally, they have a configuration in which the solar cells are sealed with a synthetic resin, covered with a transparent strengthened glass on the sunlight-exposed face, and protected with a back sheet on the opposite face. The back sheet for solar cells used then is for example a laminate of an aluminum foil and a resin film or a laminate of multiple resin films different in composition (see, for example, Patent Documents 1 to 5).

For example, for improvement of weather resistance, Patent Document 1 proposes a rear face-protection sheet for solar cells in the configuration of a laminate of polyethylene-based resins each having a particular density or a laminate of a polyethylene-based resin having a particular density and a thermoplastic polyester resin film. Alternatively, Patent Document 2 proposes an integrated back sheet having an external surface film and a moisture-proof film adhered with an adhesive based on an ethylene-vinyl acetate copolymer. In the backsheet described in Patent Document 2 above, a base film carrying an inorganic oxide film coated on the surface is used as the moisture-proof film and a fluoroplastic film as the external surface film.

Alternatively in the rear face-protection sheet for solar cell modules described in Patent Document 3, a heat-resistant polypropylene-based resin film containing a colorant additive, an ultraviolet absorbent, and a photostabilizer is laminated on both faces of a base film having a vapor-deposited film of an inorganic oxide. Generally in a backsheet for solar cells made of such a multilayer sheet, multiple films are laminated with an adhesive. Patent Document 4 proposes use of a hydrolysis-resistant, electrically insulating, and water-blocking acrylic adhesive during lamination of a polyester base material, a polycarbonate-based material, a fluorine-based, or an acrylic material.

On the other hand in the rear face-protection sheet for solar cell modules described in Patent Document 5, a fluoroplastic layer having a halogen mass ratio of 50% or more is laminated on one or both faces of the base polyphenylene ether sheet for improvement of flame resistance.

### Citation List

### Patent Literatures

[Patent Document 1] JP-A No. H11-261085
[Patent Document 2] JP-A No. 2000-294813
[Patent Document 3] JP-A No. 2003-168814
[Patent Document 4] JP-A No. 2009-246360
[Patent Document 5] JP-A No. 2011-176193

### Summary of Invention

### Technical Problem

However, there are still problems in the conventional technology described above. Specifically, although the conventional multilayer sheets described above are fairly satisfactory in weather resistance, heat resistance, moisture resistance, and other properties, they still demands further improvement of these properties for use in backsheets for solar cells and solar cell modules using the same.

In addition, because solar cell modules are often installed for example on the roof of houses, they should be flame resistant. Although the rear face-protection sheet for solar cell modules described in Patent Document 5 seems to be flame resistant, as it is difficult to provide a sheet with high adhesive strength if a polyphenylene ether sheet and a fluoroplastic layer are laminated and integrated with an adhesive, such a sheet is lower in reliability of weather resistance and heat resistance.

In addition, polyphenylene ether resins and the sheets thereof and also fluoroplastics and the sheets thereof are expensive. Further for lamination and integration of the sheets with an adhesive, a series of long steps including forming and winding of the respective sheets, application of adhesive, drying, and bonding are required. It is thus difficult to cut cost or produce the sheet cost-effectively, and the rear face-protection sheets in such a configuration are practically not commercialized or provided for practical use.

Accordingly, an object of the present invention is to provide a multilayer sheet with favorable interlayer adhesion that is flame-resistant and superior in weather resistance, heat resistance, and moisture resistance, and a backsheet for solar cell and a solar cell module prepared by using the same.

### Solution to Problem

After intensive studies to solve the problems above, the inventors obtained the following findings. First, the inventors have found that it is possible to produce a laminate with favorable flame resistance that satisfies the requirements in weather resistance, heat resistance, moisture resistance, electric insulating properties, and other properties demanded for the backsheets of solar cells, by laminating a resin layer of a polyphenylene ether-based resin composition and a resin layer of a polyvinylidene fluoride-based resin composition.

Then, the inventors studied the method of laminating these resin layers. When multiple films are bonded with an adhesive, as in conventional multilayer sheets, its production demands the steps of forming films of the resins, winding the films, applying an adhesive thereto, drying the coated films, and bonding the films, which increases the processing cost. Possible methods for eliminating these steps include, for example, a coextrusion film-forming method of melting the resins for respective layers in an extruder and layering and bonding them to each other in the molten state, a method of forming and bonding an adhesive layer and the layers to be bonded to each other simultaneously, and the like.

However, the methods such as coextrusion film-forming are not practically used for production of multilayer sheets containing a polyvinylidene fluoride-based resin, as it is difficult to assure favorable interlayer adhesive strength and additionally, the methods often cause problems such as melt fracture due to the difference in flowability among the layers and fluctuation in thickness due to draw resonance. In addition, bonding of a resin layer of a polyphenylene ether-based resin composition with a resin layer of a polyvinylidene fluoride-based resin composition by coextrusion often results in insufficient interlayer adhesion.

Thus, the inventors have studied intensely the resin composition to make the flowability of the layers uniformized and the adhesion resin most suited for adhesion by coextrusion method.

As a result, they have found that it is possible to obtain a multilayer sheet lower in fluctuation of the thickness of the layers and superior in interlayer adhesion and others, when the polyphenylene ether-based resin layer is a polyphenylene ether-containing resin composition (e.g., a resin composition containing an alloyed resin of polyphenylene ether/other resin) and the adhesion resin layer is a layer of an acrylic resin or a polymer having a structural unit derived from conjugated diene and made the present invention.

Thus, the multilayer sheet according to the present invention is a multilayer sheet, comprising a first resin layer of a polyphenylene ether-containing resin composition, a second resin layer of a polyvinylidene fluoride-based resin composition, and an adhesion resin layer, which is placed between the first and second resin layers, of one or more resins selected from acrylic resins and polymers having a structural unit derived from conjugated diene, wherein the adhesion resin layer is fused both to the first and second resin layers.

The adhesion resin layer may contain, as the polymer having a structural unit derived from conjugated diene, one or more resins selected from conjugated diene-based polymers, the hydrogenation products thereof, or the urethane- or maleic acid-modified products of the hydrogenation products, and also copolymers of a conjugated diene having 4 to 8 carbon atoms with aromatic vinyl compounds, the hydrogenation products thereof, or the urethane- or maleic acid-modified products of the hydrogenation products.

The first resin layer in the multilayer sheet may be made of a resin composition containing polyphenylene ether in an amount of 20 to 80 mass %. The first resin layer may contain one or more resins selected from copolymers of a conjugated diene having 4 to 8 carbon atoms with other monomers or the hydrogenation products thereof, copolymers of a conjugated diene having 4 to 8 carbon atoms with aromatic vinyl compounds or the hydrogenation products thereof, homopolymer of an olefinic hydrocarbon having 2 to 20 carbon atoms or the copolymer thereof, copolymer of an olefinic hydrocarbon having 2 to 20 carbon atoms with other monomers, and polystyrenes, in an amount of 80 mass % or less.

The polyvinylidene fluoride-based resin composition constituting the second resin layer may contain a white inorganic pigment in an amount of 1 to 40 parts by mass with respect to 100 parts by mass of a resin component consisting of polyvinylidene fluoride: 50 to 99 mass % and polymethyl methacrylate: 1 to 50 mass %.

The first resin layer has a thickness for example of 50 to 500 µm and the second resin layer and the adhesion resin layer may have a thickness for example of 5 to 50 µm.

Further, the resin composition constituting the first resin layer may contain a flame retardant and/or a weather-resistance improver added thereto.

Further, the first resin layer and the second resin layer may have a melt flow rate at 230°C under a load of 2.16 kg, as determined by Method A specified by JIS K7210), of 0.5 to 25 g/10 minutes and the adhesion resin layer may have a melt flow rate at 230°C under a load of 2.16 kg, as determined by Method A specified by JIS K7210, of 0.1 to 50 g/10 minutes.

On the other hand, the multilayer sheet may be prepared by lamination of the first resin layer, the second resin layer, and the adhesion resin layer by coextrusion method and, for example, it may be prepared by melt coextrusion molding in a temperature range of 130 to 260°C. The first resin layer, the adhesion resin layer, and the second resin layer separately formed may be laminated in that order and pressed under a temperature condition allowing melting or softening of the respective resin layers for interlayer fusion of the respective resin layers.

Further, a third resin layer containing an ethylene vinyl acetate copolymer as resin component may be laminated on the first resin layer.

The back sheet for solar cells according to the present invention is prepared by using the multilayer sheet described above.

The solar cell module according to the present invention is prepared by using the back sheet described above.

### Advantageous Effects of Invention

It is possible according to the present invention to obtain a multilayer sheet that is superior in weather resistance, heat resistance, and moisture resistance, has favorable flame resistance, and is favorable in interlayer adhesion, as a first resin layer of a polyphenylene ether-containing resin composition and a second resin layer of a polyvinylidene fluoride-based resin composition are laminated, as they are fused, to a particular adhesion resin layer that is placed between them.

### Brief Description of Drawings

Figure 1 is a schematic view illustrating the configuration of a multilayer sheet in the first embodiment of the present invention.
Figure 2 is a schematic sectional view illustrating the configuration of a solar cell module in the third embodiment of the present invention.

### Description of Embodiments

Hereinafter, favorable embodiments of the invention will be described in detail with reference to attached drawings. The present invention is not limited to the embodiments described below.

### (First embodiment)

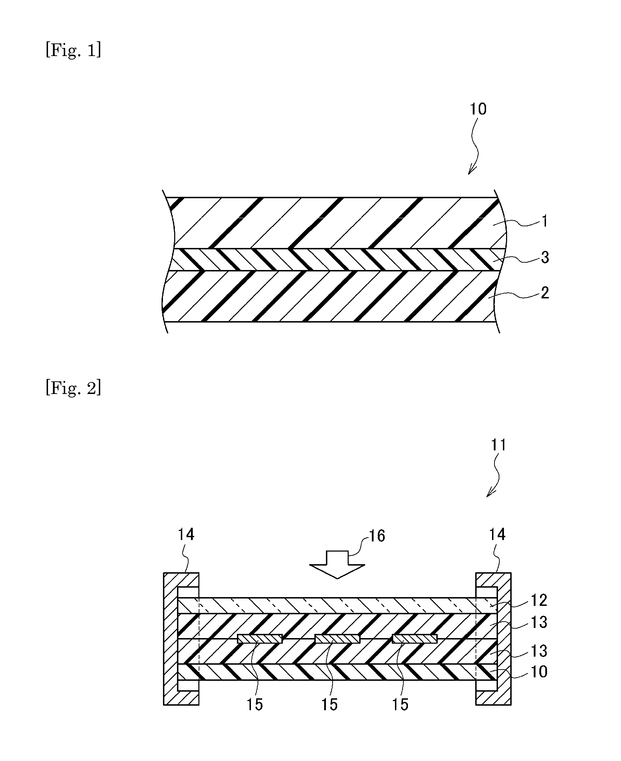

First, a multilayer sheet in the first embodiment of the present invention will be described. Figure 1 is a schematic Figure illustrating the multilayer sheet in the present embodiment. As shown in Figure 1, in the multilayer sheet 10 of the present embodiment, a resin layer 1 of a resin composition containing polyphenylene ether (hereinafter, referred to also as "polyphenylene ether-containing resin layer 1" or "first resin layer 1") and a resin layer 2 of a polyvinylidene fluoride-based resin composition (hereinafter, referred to also as "polyvinylidene fluoride-based resin layer 2" or "second resin layer 2") are laminated to each other via an adhesion resin layer of one or more adhesives selected from acrylic resins and polymers containing a structural unit derived from conjugated diene. The multilayer sheet 10 is a sheet consisting of an adhesion resin layer 3, a polyphenylene ether-containing resin layer 1, and a polyvinylidene fluoride-based resin layer 2 that are fused to each other.

### [Polyphenylene ether-containing resin layer 1]

The polyphenylene ether-containing resin layer 1 (first resin layer 1) is configured with a resin composition at least containing polyphenylene ether (hereinafter, referred to also as "polyphenylene ether-containing resin composition"). Examples of the polyphenylene ether-containing resin compositions include those in which polyphenylene ether is mixed with other resins and those in which polyphenylene ether is alloyed with other resins. In particular, resin compositions in which polyphenylene ether is alloyed with other resins are used favorably from the viewpoint of mechanical properties, molding processability, and others.

The content of the polyphenylene ether in the polyphenylene ether-containing resin composition is preferably 20 to 80 mass %, more preferably 40 to 80 mass %, still more preferably 60 to 80 mass %, from the viewpoints of the peeling strength, moisture permeability, and flame-resistance of the multilayer sheet. For improvement of flame resistance, the content of polyphenylene ether is preferably higher in the range that does not lead to reduction of the peeling strength between the sheet and the adhesion resin layer when the resin composition is sheeted or to drastic increase of the moisture permeability of the sheet. When the content of the polyphenylene ether in the polyphenylene ether-containing resin composition is in the favorable range described above, it is possible to provide the sheet with favorable adhesive strength and steam barrier properties and to increase the flame resistance thereof.

The "other resin" other than polyphenylene ether in the polyphenylene ether-containing resin composition that can be used is one or more resins selected from homopolymers of a conjugated diene having 4 to 8 carbon atoms, copolymers of a conjugated diene having 4 to 8 carbon atoms with other monomers or the hydrogenation products thereof, copolymer of a conjugated diene having 4 to 8 carbon atoms with aromatic vinyl compounds or the hydrogenation products thereof, homopolymers of an olefinic hydrocarbon having 2 to 20 carbon atoms or copolymers thereof, copolymers of an olefinic hydrocarbon having 2 to 20 carbon atoms with other monomers, and polystyrene.

The content of the "other resins" in the polyphenylene ether-containing resin composition is preferably 80 mass % or less, more preferably 20 to 80 mass %, still more preferably 20 to 60 mass %, further more preferably 20 to 40 mass %, from the viewpoints of the peeling strength, moisture permeability, and flame resistance of the multilayer sheet. It is possible in the range above to obtain favorable adhesion between the sheet and the adhesion resin layer when the resin composition is sheeted and favorable moisture-barrier property of the sheet and to increase the flame resistance thereof.

When the polyphenylene ether-containing resin composition has a composition described above, the multilayer sheet obtained therefrom shows favorable mechanical strength and modulus of elasticity and also shows improved handleability. Because such a multilayer sheet is superior in thermal durability and flame resistance, it can be used favorably as a backsheet for solar cells.

Examples of the "other resins" include "homopolymers of a conjugated diene having 4 to 8 carbon atoms," "copolymers of a conjugated diene having 4 to 8 carbon atoms with other monomers or the hydrogenation products thereof," and "copolymer of a conjugated diene having 4 to 8 carbon atoms with aromatic vinyl compounds or the hydrogenation products thereof." The "conjugated dienes" above is, for example, one or more dienes selected from 1,3-butadiene (butadiene), 2-methyl-1,3-butadiene (isoprene), 2,3-dimethyl-1,3-butadiene, 1,3-pentadiene, 1,3-hexadiene, and 2-methyl pentadiene. In particular, butadiene and isoprene are favorable.

Examples of the conjugated diene-based polymers and copolymers for use include polybutadiene, polyisoprene, butadiene-styrene copolymers, isoprene-styrene copolymers, and the like as well as the hydrogenation products thereof.

The "aromatic vinyl compound" in the "copolymer of a conjugated diene having 4 to 8 carbon atoms with aromatic vinyl compounds or the hydrogenation product thereof" is, for example, one or more compounds selected from o-methylstyrene, p-methylstyrene, p-tert-butylstyrene, 1,3-dimethylstyrene, α-methylstyrene, vinylnaphthalene, vinylanthracene, 1,1-diphenylethylene, and the like.

The "copolymer of a conjugated diene having 4 to 8 carbon atoms with aromatic vinyl compounds" for use is for example a butadiene-styrene copolymer such as styrene-butadiene-styrene block copolymer (SBS), an isoprene-styrene copolymer such as styrene-isoprene-styrene block copolymer (SIS), or the hydrogenation product thereof. Examples of the hydrogenation products for use include SBS hydrogenation products such as styrene-butadiene-butylene-styrene block copolymers (SBBSs) and styrene-ethylene-butylene-styrene block copolymers (SEBSs), and SIS hydrogenation products such as styrene-ethylene-propylene-styrene block copolymers (SEPSs).

The "other resin" is, for example, a "homopolymer of an olefinic hydrocarbon having 2 to 20 carbon atoms or a copolymer thereof (copolymer of olefinic hydrocarbons each having 2 to 20 carbon atoms)." Examples of the "homopolymers of an olefinic hydrocarbon having 2 to 20 carbon atoms or the copolymers thereof" include low-density polyethylenes, medium-density polyethylenes, high-density polyethylenes, straight-chain (linear) low-density polyethylenes, polypropylenes, propylene-ethylene-based copolymers, propylene-butene-based copolymers, polymethylpentenes, ethylene-polymethylpentene-based copolymers, and the like. In addition, cyclic olefinic homopolymers such as polynorbornene and cyclic olefinic copolymers such as ethylene-norbornene-based copolymers and propylene-norbornene-based copolymers can also be used. In the case of a stereoregular resin, the stereoregularity may be either isotactic, syndiotactic, or atactic.

The "other resin" is for example a "copolymer of an olefinic hydrocarbon having 2 to 20 carbon atoms with other monomers." Examples of the "other monomers" in the "copolymer of an olefinic hydrocarbon having 2 to 20 carbon atoms with other monomers" include acrylic acid and the derivatives thereof, methacrylic acid and the derivatives thereof, maleic anhydride and the derivatives thereof, carboxylic acid vinyl esters, and the like.

Examples of the "copolymers of an olefinic hydrocarbon having 2 to 20 carbon atoms with other monomers" for use include ethylene-vinyl acetate copolymers, ionomer resins, ethylene-ethyl acrylate copolymers, ethylene-acrylate copolymers, ethylene-methacrylate copolymers, acid-modified polyolefin-based resins such as those obtained by modifying polyethylene or polypropylene with an unsaturated carboxylic acid such as acrylic acid, methacrylic acid, maleic anhydride, fumaric acid, itaconic acid, and the like.

These polymers that can be used as the "other resins" above may be used alone or in combination of two or more.

In order to achieve the object of the present invention, one or more resins selected from SEBSs (hydrogenation products of SBSs) and common polystyrenes (GPPSs) are preferably used as the resin to be alloyed with the polyphenylene ether.

On the other hand, a flame retardant may be added, additionally as needed, to the resin composition constituting the polyphenylene ether-containing resin layer 1. The flame retardant to be added is not particularly limited, and examples thereof for use include chlorine-based flame retardants, bromine-based flame retardants, phosphorus-based flame retardants, inorganic flame retardants, and the like. Examples of the chlorine-based flame retardants include chlorinated paraffins, perchlorocyclopentadecane, chlorendic acid, and the like. Examples of the bromine-based flame retardants include tetrabromobisphenol A (TBBPA), decabromodiphenyl oxide, TBA epoxy oligomers, TBA polycarbonate, octabromodiphenylether, tribromophenol, and the like.

Examples of the phosphorus-based flame retardants include triphenyl phosphate, tricresyl phosphate, trixylenyl phosphate, tributyl phosphate, tris-chloroethyl phosphate, tris-chloropropyl phosphate, and the like. Examples of the inorganic flame retardants include aluminum hydroxide, magnesium hydroxide, antimony trioxide, and the like.

In addition, weather-resistance improvers such as ultraviolet absorbents, photostabilizers, and antioxidants may be added to the resin composition constituting the polyphenylene ether-containing resin layer 1. It is possible by adding these weather-resistance improvers to improve the lightfastness and durability of the multilayer sheet 10 further. The weather-resistance improver added is not particularly limited, and examples of the ultraviolet absorbents for use include benzophenone-, benzotriazole-, salicylate-, acrylonitrile-, and metal complex salt-based ultraviolet absorbents, ultrafine-particle titanium oxide and zinc oxide, and the like.

Examples of the photostabilizers for use include hindered amine compounds, hindered piperidine compounds, and the like. Further, examples of the antioxidant for use include phenol-, amine-, sulfur-, and phosphoric acid-based antioxidants and the like. In addition, a polymeric ultraviolet absorbent, a photostabilizer, an antioxidant, or the like containing a benzophenone-based ultraviolet absorbent described above, a hindered amine compound-based photostabilizer, or a phenol-based antioxidant chemically bound to the main or side chain of the polymer can also be used.

When weather-resistance improvers such as an ultraviolet absorbent, a photostabilizer, and an antioxidant are contained, the total amount thereof is desirably 0.1 to 10 mass % in the composition for expression of the advantageous effects of the weather-resistance improvers without deterioration of mechanical properties such as impact strength. The weather-resistance improvers may be used alone or in combination with the flame retardants described above.

### [Polyvinylidene fluoride-based resin layer 2]

The polyvinylidene fluoride-based resin layer 2 (second resin layer 2) is made of a polyvinylidene fluoride-based resin composition containing a polyvinylidene fluoride resin in an amount of 50 mass % or more with respect to all resin components. The polyvinylidene fluoride resin blended in the polyvinylidene fluoride-based resin composition is preferably a vinylidene fluoride homopolymer, but may be a copolymer of vinylidene fluoride with other monomers.

Examples of the other monomers copolymerized with vinylidene fluoride include fluorinated vinyl compounds such as vinyl fluoride, tetrafluoroethylene, trifluorochloroethylene, hexafluoropropylene, hexafluoroisobutylene, and various fluoroalkyl vinylethers; known vinyl monomers such as styrene, ethylene, butadiene, and propylene; and the like. However, for assurance of weather resistance and photostability over the polyvinylidene fluoride-based resin layer 2 and the multilayer sheet 10, the content of the monomers other than vinylidene fluoride in the polyvinylidene fluoride resin is desirably 50 mass % or less.

The method for producing the polyvinylidene fluoride resin described above is not particularly limited, and it can be prepared by a common method such as suspension polymerization or emulsion polymerization. For example, a solvent such as water, a polymerization initiator, a suspending agent (or emulsifier), a chain-transfer agent, and others are placed in a tightly sealed reactor; gaseous vinylidene fluoride monomer is introduced into the reactor under reduced pressure produced by deaeration; and the vinylidene fluoride monomer is polymerized, while the reaction temperature is controlled. The polymerization initiator used then may be an inorganic peroxide such as a persulfate salt, an organic peroxide such as di-n-propylperoxydicarbonate (NPP) or diisopropylperoxydicarbonate, or the like.

Examples of the chain-transfer agents include acetone, isopropyl acetate, ethyl acetate, diethyl carbonate, dimethyl carbonate, ethyl carbonate, propionic acid, trifluoroacetic acid, trifluoroethylalcohol, formaldehyde dimethyl acetal, 1,3-butadiene epoxide, 1,4-dioxane, B-butylolactone, ethylene carbonate, vinylene carbonate, and the like. Among the various chain-transfer agents, acetone and ethyl acetate are favorable from the viewpoint of availability and handleability. Further, examples of the suspending agents (or emulsifiers) for use include partially saponified polyvinylalcohols, water-soluble cellulose ethers such as methylcellulose and hydroxyethylcellulose, water-soluble polymers such as acrylic acid-based polymers and gelatin, and the like.

On the other hand, the polyvinylidene fluoride-based resin composition may contain a resin other than polyvinylidene fluoride resin and methacrylic ester resins are favorable from the viewpoints of flexibility and processability. The "methacrylic ester resin," as used herein, is for example a polymethacrylic ester obtained by radical polymerization of methacrylic ester prepared, for example, by the ACH, modified ACH, direct, or ethylene method.

When processed into a film, the methacrylic ester resin has an action to increase adhesiveness to other resins. Although polyvinylidene fluoride resins are lower in adhesiveness to other materials, they become more adhesive when blended with a methacrylic ester resin. However, when the methacrylic ester resin content in the resin components is more than 50 mass %, the resin becomes less weather resistant, as the content of the polyvinylidene fluoride resin decreases. Alternatively when the methacrylic ester resin content is less than 1 mass %, the favorable effect of the addition described above is not obtained. Thus, the amount of the methacrylic ester resin, if blended, is desirably 1 to 50 mass % with respect to the total amount of the resin components.

The methacrylic ester resin blended in the polyvinylidene fluoride-based resin composition is not particularly limited for example in its structure, if it is a vinyl polymer based on a methacrylic ester monomer. Examples of the methacrylic ester monomers include methyl methacrylate, ethyl methacrylate, propyl methacrylate, butyl methacrylate, pentyl methacrylate, hexyl methacrylate, and the like. Among these, methyl methacrylate is particularly preferable. The alkyl group in the methacrylic ester monomer, such as propyl, butyl, pentyl, or hexyl, may be a straight- or branched-chain group.

The methacrylic ester resin blended in the resin composition in the embodiment may be a homopolymer of a methacrylic ester monomer or a copolymer of multiple methacrylic ester monomers. Alternatively, it may contain a monomer unit derived from a known vinyl compound other than methacrylic esters, such as ethylene, propylene, butadiene, styrene, α-methylstyrene, acrylonitrile, or acrylic acid.

The polyvinylidene fluoride-based resin composition constituting the polyvinylidene fluoride-based resin layer 2 may contain, as needed, a white inorganic pigment such as magnesium oxide, barium sulfate, titanium oxide, basic lead carbonate, or zinc oxide for improvement of photoreflectivity. When the multilayer sheet 10 of the present embodiment is used in the solar cell application, rutile-type crystalline titanium dioxide is favorable among various white inorganic pigments, as it is higher in refractive index and coloring power and lower in photocatalytic activity.

However, when the blending amount of the white inorganic pigment is less than 1 part by mass with respect to 100 parts by mass of the resin components, it may not be possible to obtain desired photoreflection properties and, when it is more than 40 parts by mass with respect to 100 parts by mass of the resin components, the pigment may be dispersed unevenly in the composition, making it difficult to form a film. Accordingly when a white inorganic pigment is blended in the polyvinylidene fluoride-based resin composition, the addition amount is preferably 1 to 40 parts by mass with respect to 100 parts by mass of the resin components.

The amount of the white inorganic pigment blended is more preferably 10 to 35 parts by mass and still more preferably 15 to 30 parts by mass, with respect to 100 parts by mass of the resin components. It is thus possible to obtain a multilayer sheet higher in sunlight reflectance, appropriate in mechanical strength and flexibility and favorable in handleability.

The polyvinylidene fluoride-based resin composition may contain a white inorganic pigment described above and an inorganic coloring pigment in combination. The inorganic coloring pigment for use may be, for example, a complex oxide pigment prepared by using two or more oxides selected from the metal materials such as chromium, zinc, iron, nickel, aluminum, cobalt, manganese, and copper and converting them into solid solution by sintering. The complex oxide pigments may be used alone or in combination of two or more.

When an inorganic coloring pigment is blended in the polyvinylidene fluoride-based resin composition, its addition amount is preferably 0.01 to 7 parts by mass, more preferably 0.1 to 5 parts by mass, and still more preferably 0.5 to 3 parts by mass, with respect to 100 parts by mass of the resin components. It is possible in this way to regulate the sunlight reflectance in the range that does not impair the power-generating characteristics of the solar cell module and to modify the appearance and the color of the solar cell module.

The polyvinylidene fluoride-based resin composition described above is prepared by mixing, as needed, a methacrylic ester resin, a white inorganic pigment and an inorganic coloring pigment, and others with the polyvinylidene fluoride resin and melt-extruding the mixture. Various mixers and kneaders equipped with a heating device such as twin-screw extruders and continuous and batch kneaders can be used then for melt extrusion, but the apparatus most favorable for melt extrusion is a twin-screw extruder from the point of flexibility in use. Alternatively, a dispersant may be added, as needed, during the melt extrusion in an amount in the range that does not impair the favorable effects described above.

### [Adhesion resin layer 3]

The adhesion resin layer 3 is prepared, using one or more resins selected from acrylic resins and polymers having a structural unit derived from conjugated diene. When such resins are used as the adhesion resin layer 3, the polyphenylene ether-containing resin layer 1 and the polyvinylidene fluoride-based resin layer 2 can be adhered to each other tightly and the favorable adhesiveness can be retained as stabilized even at a high temperature of around 120°C. As a result, the multilayer sheet 10 becomes sufficiently durable under the use environment of solar cell modules.

The acrylic resin that can be used as the adhesion resin layer 3 is one or more resins selected from acrylic and methacrylic ester polymers. Typical examples thereof include poly(methyl acrylate), poly(ethyl acrylate), poly(propyl acrylate), poly(butyl acrylate), poly(pentyl acrylate), poly(hexyl acrylate), poly(methyl methacrylate), poly(ethyl methacrylate), poly(propyl methacrylate), butyl methacrylate, pentyl methacrylate, hexyl methacrylate, and the like. In particular, poly(methyl methacrylate) is preferable as the acrylic resin of the adhesion resin layer 3 in order to achieve the object of the present invention.

The polymer having a structural unit derived from conjugated diene of the adhesion resin layer 3 for use may be one or more selected from conjugated diene-based polymers, the hydrogenation products thereof, and urethane- and maleic acid-modified products of the hydrogenation products as well as copolymers of a conjugated diene having 4 to 8 carbon atoms with aromatic vinyl compounds, the hydrogenation products thereof, and the urethane- or maleic acid- modified products of the hydrogenation products.

The conjugated diene of the "polymer having a structural unit derived from conjugated diene" is preferably butadiene (1,3-butadiene) or isoprene. Examples of the conjugated diene-based homopolymers in the conjugated diene-based polymers include polybutadiene, polyisoprene, and the like.

Examples of the copolymers in the "polymer having a structural unit derived from a conjugated diene" include butadiene-styrene copolymers, isoprene-styrene copolymers and the like. More specific examples thereof include styrene-butadiene-styrene block copolymers (SBSs), styrene-isoprene-styrene block copolymers (SISs), styrene-butadiene-isoprene-styrene block copolymers (SBISs), and the like.

Examples of the "hydrogenation products of the copolymers of a conjugated diene having 4 to 8 carbon atoms with aromatic vinyl compounds" include hydrogenated butadiene-styrene copolymers, hydrogenated isoprene-styrene copolymers, and the like. More specific examples thereof include hydrogenation products of SBS such as styrene-butadiene-butylene-styrene block copolymers (SBBSs) and styrene-ethylene-butylene-styrene block copolymers (SEBSs), hydrogenation products of SISs such as styrene-ethylene-propylene-styrene block copolymers (SEPSs), hydrogenation products of SBISs such as styrene-ethylene-ethylene-propylene-styrene block copolymers (SEEPSs), and the like.

From the viewpoints of the long-term durability and adhesive strength of the adhesion resin, the adhesion resin layer 3 is preferably formed with a copolymer of a conjugated diene having 4 to 8 carbon atoms with aromatic vinyl compounds, a hydrogenation product thereof, or a urethane- or maleic acid-modified product of the hydrogenation product. Favorable among them are hydrogenation products of copolymers of a conjugated diene having 4 to 8 carbon atoms with aromatic vinyl compounds (such as hydrogenation products of butadiene-styrene copolymers and hydrogenation products of isoprene-styrene copolymers), the urethane- or maleic acid-modified products of the hydrogenation products.

Preferably from the viewpoint of strength, the adhesion resin layer 3 is a hydrogenation product of a block-type copolymer of a conjugated diene and aromatic vinyl compounds such as hydrogenated SBS product (e.g., SEBS) and hydrogenated SIS product (e.g., SEPS). The type of block copolymerization is not particularly limited and the block copolymer may be a diblock, triblock, multi-block, or star-shaped copolymer. In addition, these polymers may be modified, for example, by terminal modification.

### [Thickness]

The thickness of each layer described above is not particularly limited and can be set to an arbitrary value according to the application and the properties desired. For example, the polyphenylene ether-containing resin layer 1 may have a thickness of 50 to 500 µm, and the polyvinylidene fluoride resin layer 2 and the adhesion resin layer 3 may each have a thickness of 5 to 50 µm.

When the polyphenylene ether-containing resin layer 1 has a thickness of less than 50 µm, if the multilayer sheet 10 is used in a solar cell module, the multilayer sheet 10 has insufficient mechanical strength, making the solar cells easily damaged, and insufficient steam barrier property, leading to deterioration of the cell and reduction of the power output. Alternatively when the polyphenylene ether-containing resin layer 1 has a thickness of more than 500 µm, the multilayer sheet 10 becomes more rigid, leading to decrease in handleability (such as winding efficiency) and additionally to increase of production cost.

Alternatively when the polyvinylidene fluoride-based resin layer 2 has a thickness of less than 5 µm, the multilayer sheet 10 becomes less weather-resistant and if the multilayer sheet 10 is used in a solar cell module, it often shows insufficient durability. Alternatively when the polyvinylidene fluoride-based resin layer 2 has a thickness of more than 50 µm, the production cost increases.

Yet alternatively when the adhesion resin layer 3 has a thickness of less than 5 µm, the polyphenylene ether-containing resin layer 1 and the polyvinylidene fluoride-based resin layer 2 have insufficient adhesive strength, easily leading to layer separation. As a result, if the multilayer sheet 10 is used in a solar cell module, it may become not durable enough. Alternatively when the adhesion resin layer 3 has a thickness of more than 50 µm, the production cost increases.

### [MFR]

Preferably, the polyphenylene ether-containing resin layer 1 and the polyvinylidene fluoride-based resin layer 2 have a melt flow rate (MFR) at 230°C under a load of 2.16 kg, as determined by the Method A specified in JIS K7210, of 0.5 to 25 g/10 minutes and the polymer constituting the adhesion resin layer 3 has an MFR of 0.1 to 50 g/10 minutes.

In this way, when the resins are formed into a film by melt coextrusion molding method, the resins in the molten state flow in respective channels in uniformized flow rate distribution and join at the same speed and are discharged from the dice in the state without fluctuation in speed. It is thus possible to produce a multilayer sheet in which the constituent layers are bonded favorably to each other with lower fluctuation in thickness among them. In addition, the pigment contained in the polyvinylidene fluoride-based resin composition becomes more favorably dispersed, preventing generation of defects.

If a film is formed by coextrusion molding method, the resin compositions used for preparation of the polyvinylidene fluoride-based resin layer 2 and the adhesiveness resin layer 3 each preferably have an MFR of 0.1 to 10 times, preferably 0.2 to 5 times larger than that of the polyphenylene ether-containing resin layer 1. It is possible in this way to stabilize film-forming process and suppress fluctuation in thickness of the respective layers in the width direction of the sheet.

The MFR of each resin layer can be adjusted by modifying the polymerization degree (or molecular weight) of the resin component contained therein. Specifically, it can be adjusted, for example, by modifying the polymerization temperature, the kind and amount of the polymerization initiator or the kind and amount of the chain-transfer agent used when the resin components are polymerized. Alternatively, a commercially available resin may be used to make the MFR of each resin layer fall in the range described above.

### [Production method]

Hereinafter, the method for producing the multilayer sheet 10 in the configuration described above will be described.

The multilayer sheet 10 of the present embodiment is preferably prepared by a coextrusion method of melting the resin compositions constituting the polyphenylene ether-containing resin layer 1 and the polyvinylidene fluoride-based resin layer 2 and the polymer constituting the adhesion resin layer 3 respectively in separate extruders and joining and integrating the molten resins.

It is preferable in this case to perform the melt coextrusion molding at a material temperature of 130 to 260°C. It is thus possible to bring the resin compositions and the polymer constituting the respective layers into the stabilized melt flow state and prevent generation of thermal decomposition and other unfavorable phenomena. If the material temperature is less than 130°C during film-forming, the resins melt insufficiently, possibly generating fish eyes in the sheet and leading to insufficient adhesion between the layers. Alternatively when the material temperature is more than 260°C during film-forming, the resin components constituting the layers may decompose thermally, possibly giving a colored sheet, or generating decomposition gases. The material temperature during film-forming is more preferably 180 to 250°C.

The coextrusion can be performed, for example, by T die coextrusion method or inflation coextrusion method. The extruder for use may be, for example, a single-screw extruder or a twin-screw (multiaxial) extruder, and the cylinder and the screw of the extruder for use may be those commonly used. Further, the twin-screw extruder, if used, may be an extruder having two screws in parallel or a conical extruder having oblique screw axes. It may be an extruder with its screw flights intermeshed or non-intermeshed with it screw rotations in the same direction or in the opposite direction.

As for screw design in the case of a single-screw extruder, various mixers such as Dulmage-, rotor-, flute mixing-type mixers can be used as the mixing unit and the resins can be melted and sheeted in an extruder having no such a mixing unit. In the case of a twin-screw extruder, a kneading disk, a rotor segment, a reverse screw flight, or the like may be used as the mixing unit, but a full-flight screw having no such a mixing unit may also be used. The cylinder for use may be a vent- or no-vent-type cylinder.

The polyphenylene ether-containing resin layer 1, the polyvinylidene fluoride-based resin layer 2, and the adhesion resin layer 3 can be laminated, and thus the multilayer sheet 10 formed, for example, by a method of joining the resins in a feed block, discharging the mixture for example through a flat die (T die) and withdrawing the sheet extruded in the molten state, as it is cooled. The flat die used then may be a T-shaped manifold die, a fish-tail die, a coat-hanger die, a screw die, or the like. It is also possible to use, for example, a method of feeding the resin components to a multi-manifold die and discharging a sheet therefrom in the molten state or a method of discharging it out of an inflation die.

When a film is produced by the coextrusion method, it is possible to adjust the thickness of each resin layer in the range described above by modifying the rate of discharging the material from the extruder. In the case of a single-screw extruder, the discharge rate is regulated by modification of the screw rotation frequency. Alternatively in the case of a twin-screw extruder, it can be regulated by modification of the rate of the raw materials fed into the extruder from the feeders, the screw rotation frequencies of the extruder, or the rotation frequencies of the gear pumps.

Alternatively, the polyphenylene ether-containing resin layer 1, the adhesion resin layer 3, and the polyvinylidene fluoride-based resin layer 2 separately formed may be laminated in that order and the resin layers bonded to each other, as they are pressed under a temperature condition permitting melting or softening of these resin layers (e.g., 130°C to 260°C).

It is possible by the coextrusion method described above to obtain a multilayer sheet 10 in which a polyphenylene ether-containing resin layer 1 and an adhesion resin layer 3 are fused and also a polyvinylidene fluoride-based resin layer 2 and an adhesion resin layer 3 are fused to each other.

In the coextrusion method, resin compositions constituting respectively the polyphenylene ether-containing resin layer 1 and the polyvinylidene fluoride-based resin layer 2 and the polymer constituting the adhesion resin layer 3 are molten and the molten resins are laminated by the coextrusion method. Thus in the multilayer sheet 10, the interface between the polyphenylene ether-containing resin layer 1 and the adhesion resin layer 3 and also the interface between the polyvinylidene fluoride-based resin layer 2 and the adhesion resin layer 3 may be in the thermally fused state.

As respective resin layers are bonded to each other in the molten or softened state, as described above, there is a fusion interface (wherein the interfaces of respective resin layers are bonded to each other, as fused) between the respective resin layers of the multilayer sheet 10.

According to the present invention, it is possible by using an adhesion resin layer 3 that can form a fusion interface with the polyphenylene ether-containing resin layer 1 and the polyvinylidene fluoride-based resin layer 2 to remove the concern about the damage by solvent to the resin layers 1 and 2, which is possible by the conventional solvent-type adhesives containing organic solvent and others. It is also possible according to the present invention to obtain high adhesive strength more easily, compared to conventional no-solvent-type adhesives containing no organic solvent or the like, such as hot melt adhesives, and to reduce deterioration in adhesive strength even at a high temperature of about 100°C. Further, it is possible by means of lamination by the coextrusion method to simplify the production process and reduce the production cost, as compared to lamination using an adhesive.

As described above in detail, as the multilayer sheet 10 of the present embodiment comprises a polyphenylene ether-containing resin layer 1 superior in flame resistance, moisture resistance, and mechanical properties and a polyvinylidene fluoride-based resin layer 2 superior in weather resistance, heat resistance, and flame resistance, it is a multilayer sheet superior in weather resistance and heat resistance and higher in flame resistance.

Because the adhesion resin layer 3 is made of one or more resins selected from acrylic resins and polymers having a structural unit derived from conjugated diene, the interlayer bonding strength between the polyphenylene ether-containing resin layer 1 and the polyvinylidene fluoride-based resin layer 2 is higher, sufficiently assuring favorable adhesive strength under heat and also under high-temperature high-humidity environment. Thus, the multilayer sheet satisfies the requirements in weather resistance, heat resistance, moisture resistance, and electric insulating properties over the entire sheet and also other requirements in properties demanded for solar cell backsheets. It also shows favorable flame resistance. As a result, a multilayer sheet favorable as a backsheet for solar cells is obtained.

### (Modified embodiment of the first embodiment)

Hereinafter, a multilayer sheet of a modified embodiment of the present embodiment will be described. In the multilayer sheet of the modified embodiment, an ethylene-vinyl acetate copolymer (EVA) resin layer (third resin layer) is formed at least on the polyphenylene ether-containing resin layer 1 of the multilayer sheet 10 shown in Figure 1.

### [EVA resin layer]

The EVA resin layer may be formed with an EVA resin composition commonly used as a sealing material for solar cell modules. The EVA resin composition is, for example, a composition containing an ethylene-vinyl acetate copolymer resin having a vinyl acetate content of 10 to 30 mass % as the major component and an organic peroxide that generate radicals at 100°C or higher as crosslinking agent in an amount of 1 to 5 parts by mass with respect to 100 parts by mass of the EVA resin.

In the multilayer sheet of the modified embodiment, as an EVA resin layer is formed at least on the polyphenylene ether-containing resin layer 1 and the backsheet and the sealing material are integrated, it is possible to simplify the assembly step for production of solar cell modules. Specifically, although glass, a sealant sheet, a cell, a sealant sheet and a back sheet are layered and laminated in that order in the assembly step for a solar cell module, it is possible by using the multilayer sheet to eliminate the step of laminating the sealant sheet with the back sheet. Additionally in the multilayer sheet of the modified embodiment, it is also possible to prevent the position aberration between the sealing material and the back sheet in the solar cell module.

The EVA resin layer may be formed only on the polyphenylene ether-containing resin layer 1 or both on the polyphenylene ether-containing resin layer 1 and the polyvinylidene fluoride-based resin layer 2.

### (Second embodiment)

Hereinafter, a back sheet for solar cells (hereinafter, referred to simply as back sheet) in the second embodiment of the present invention will be described. The back sheet in the present embodiment is prepared from the multilayer sheet of the first embodiment or the modified embodiment thereof described above.

The back sheet of the present embodiment can be used in various types of solar cells such as crystalline silicon-, polycrystalline silicon-, amorphous silicon-, compound-and organic-solar cells. Thin-film solar cells containing for example amorphous silicon are required to have higher moisture proofness, compared to crystal-based solar cells. In such a case, a moisture-proof layer or a moisture-proof coat layer, for example of an inorganic oxide that is higher in moisture proofness may be formed additionally on the multilayer sheet of the first embodiment or the modified embodiment thereof described above.

The backsheet of the present embodiment comprises a multilayer sheet having a polyphenylene ether-containing resin layer and a polyvinylidene fluoride-based resin layer that are bonded to each other with an adhesion resin layer made of one or more resins selected from acrylic resins and polymers having a structural unit derived from conjugated diene. In the multilayer sheet, the adhesion resin layer is fused both to the polyphenylene ether-containing resin layer and the polyvinylidene fluoride-based resin layer. As the backsheet comprises such a multilayer sheet, the backsheet is superior in various properties demanded for backsheets for solar cells, such as weather resistance, heat resistance, mechanical strength, modulus, electric insulating properties, and moisture resistance, and has favorable flame resistance, and is also superior in interlayer adhesion. Further, it is possible to produce the backsheet by means of integral molding by the coextrusion method and thus cost-effectively.

### (Third embodiment)

Hereinafter, a solar cell module in the third embodiment of the present invention will be described. Figure 2 is a schematic sectional view illustrating the solar cell module in the present embodiment. As shown in Figure 2, in the solar cell module 11 of the embodiment, solar cells 15, as photoelectromotive element, are sealed with a sealing material 13 of a synthetic resin such as an EVA resin.

A transparent substrate 12, for example of glass, is laminated on the sunlight 16-irradiation face (light-receiving surface) and the backsheet of the second embodiment described above (multilayer sheet 10) on the rear face (non-light-receiving surface), and a frame 14 is formed around the composite. The backsheet (multilayer sheet 10) is then placed in such a way that the polyphenylene ether-containing resin layer 1 faces the sealing material 13.

The solar cell module 11 of the present embodiment comprises, as the backsheet (multilayer sheet 10), a multilayer sheet comprising a polyphenylene ether-containing resin layer and a polyvinylidene fluoride-based resin layer bonded to each other with an adhesion resin layer of one or more resins selected from acrylic resins and polymers having a structural unit derived from conjugated diene. And in the multilayer sheet, the adhesion resin layer is fused both to the polyphenylene ether-containing resin layer and the polyvinylidene fluoride-based resin layer. As the solar cell module 11 comprises such a multilayer sheet, it is superior in weather resistance, heat resistance, mechanical strength, modulus, electric insulating properties and moisture resistance. It is thus possible to obtain a highly-reliable solar cell module. As described above, as the backsheet is less expensive, it is possible to reduce the production cost for solar cell modules.

### Examples

Hereinafter, advantageous effects of the present invention will be described with reference to the Inventive Examples and Comparative Examples. In the Examples below, the multilayer sheets of Examples 1 to 6 and Comparative Examples 1 and 2 were prepared by the method described below and the properties thereof after converted to a back sheet for solar cells were examined. In the description below, the value of MFR is a value as determined at 230°C under a load of 2.16 kg according to the method A of JIS K7210, unless specified otherwise.

### (Example 1)

A polyphenylene ether resin (trade name: PX-100L, produced by Mitsubishi Engineering Plastics Corp.) and a styrene-(ethylene /butylene) block-styrene copolymer (trade name: Septon 8004, produced by Kuraray Co., Ltd.) were used as the raw materials for the polyphenylene ether-containing resin layer 1 (first resin layer 1). A hydrogenation product of a polyurethane-modified styrene-isoprene-styrene block copolymer (urethane-modified SEP, trade name: Kuramiron TU-S5265 produced by Kuraray Co., Ltd.) was used as the raw material for the adhesion resin layer 3.

### <Preparation and production of the raw material for polyphenylene ether-containing resin layer 1>

A twin-screw extruder having a screw diameter of 30 mm and an L/D ratio of 40, which was equipped with a screw feeder connected to the raw material-supplying unit of the extruder and a strand die with three holes having a hole diameter of 3 mm connected to the discharge unit of the extruder, was used as the kneading apparatus for preparation of the resin composition. 80 parts by mass of a polyphenylene ether resin (trade name: PX-100L, produced by Mitsubishi Engineering Plastics Corp.) and 20 parts by mass of a block styrene-(ethylene/butylene)-styrene copolymer (trade name: Septon 8004, produced by Kuraray Co., Ltd.) were mixed in the dry state and the mixture was introduced into the screw feeder and fed at a feed rate of 30.00 kg/hour. The mixture was extruded out of the strand die at a twin-screw extruder rotational frequency of 300 rpm and a barrel temperature setting of 230°C.

The strands extruded were cooled and then cut with a pelletizer, to give 60 kg of a resin composition of pellets having a diameter of approximately 2 mm and a length of approximately 4 mm.

### <Preparation and production of the raw material for polyvinylidene fluoride-based resin layer 2>

20 kg of a crystalline rutile titanium dioxide powder as white inorganic pigment and 1 kg of a coloring pigment were made available and mixed with a mixer. A twin-screw extruder having a screw diameter of 30 mm and an L/D ratio of 40 was used as the kneading apparatus for preparation of the resin composition and three screw feeders A to C were connected to the raw material supplying unit of the extruder and a 3-hole strand die having a length of 3 mm to the discharge unit of the extruder.

A mixture of a coloring pigment and titanium dioxide was placed in feeder A, and a polyvinylidene fluoride resin having an MFR, as determined by the MFR measurement method specified by the method A of JIS K7210, of 20 g/10 minutes at 230°C under a load of 3.8 kg was placed in feeder B. In addition, a polymethyl methacrylate resin having an MFR, as determined by the MFR measurement method specified by the method A of JIS K7210, of 9 g/10 minutes at 230°C under a load of 10 kg (hereinafter, referred to as PMMA) was placed in feeder C.

The mixture of the coloring pigment and titanium dioxide placed in feeder A was fed at a feed rate of 5.25 kg/hour, the polyvinylidene fluoride resin placed in feeder B was fed at a feed rate of 20.00 kg/hour, and the PMMA placed in feeder C was fed at a feed rate of 5.00 kg/hour. And, these materials were extruded out of a strand die, as the twin-screw extruder was operated at a rotational frequency of 300 revolution/minute and a barrel temperature setting of 230°C.

The strands extruded were cooled and cut in a pelletizer, to give a pellet-shaped resin composition having a diameter of approximately 2 mm and a length of approximately 4 mm in an amount of 60 kg. The resin composition obtained had a blend composition of 80 parts by mass (66 mass %) of the polyvinylidene fluoride resin, 20 parts by mass (16 mass %) of the PMMA, 20 parts by mass (17 mass %) of the white inorganic pigment, and 1 part by mass (1 mass %) of the coloring pigment and had an MFR of 4.7 g/10 minutes.

### <Preparation of multilayer sheet>

Three single-screw extruders were connected as a triple-layer coextrusion device to a 3-kind 3-layer feed block, which is connected to a coat hanger die having a lip width of 600 mm, so that the 3-layer resin stream formed as combined in the feed block flows into the die. The tree single-screw extruders had the following specifications:
- Extruder 1 (for polyphenylene ether-containing resin layer 1): screw diameter: 90 mm, L/D: 30, screw: full-flight screw.
- Extruder 2 (for adhesion resin layer 3): screw diameter 40 mm, L/D: 30, screw: full-flight screw.

- Extruder 3 (for polyvinylidene fluoride-based resin layer 2): screw diameter 40 mm, L/D: 30, screw: full-flight screw.

Then, the raw materials for respective resin layers described above were placed in the hoppers to extruders 1 to 3 and the extruders were operated under the following conditions:
- Extruder 1 (for polyphenylene ether-containing resin layer 1): screw rotation number: 100 revolution/minute, extrusion rate: 150 kg/hour, extruder barrel temperature setting: 230°C.
- Extruder 2 (for adhesion resin layer 3): screw rotation number: 25 revolution/minute, extrusion rate: 15 kg/hour, extruder barrel temperature setting: 230°C.
- Extruder 3 (for polyvinylidene fluoride-based resin layer 2): screw rotation number: 25 revolution/minute, extrusion rate: 10 kg/hour, extruder barrel temperature setting: 230°C.

The resins extruded from the extruders 1 to 3 are mixed in the feed block, extruded out of the coat hanger die set to have a lip opening of 0.5 mm, and cooled, as the hot sheet is held between two chill rolls in a take-off machine, to give a multilayer sheet. The multilayer sheet obtained was then sent to a winding machine and wound into a roll. In the multilayer sheet of Example 1, the polyphenylene ether-containing resin layer 1 had a thickness of 300 µm, the adhesion resin layer 3 had a thickness of 20 µm, and the polyvinylidene fluoride-based resin layer 2 had a thickness of 20 µm. The layers were adhered to each other completely.

### (Example 2)

A multilayer sheet was prepared in a manner similar to Example 1 described above, except that 20 parts by mass of a polyphenylene ether resin (trade name: PX-100L, produced by Mitsubishi Engineering Plastics Corp.) and 80 parts by mass of a block styrene-(ethylene/butylene)-styrene copolymer (trade name: Septon 8004 produced by Kuraray Co., Ltd.) were used as the raw materials for the first resin layer 1. The polyphenylene ether-containing resin layer 1 had a thickness of 320 µm, the adhesion resin layer 3 had a thickness of 30 µm, and the polyvinylidene fluoride-based resin layer 2 had a thickness of 30 µm.

### (Example 3)

A multilayer sheet was prepared in a manner similar to Example 1 described above, except that 40 parts by mass of a polyphenylene ether resin (trade name: PX-100L, produced by Mitsubishi Engineering Plastics Corp.) and 60 parts by mass of a common polystyrene (GPPS) were used as the raw materials for the first resin layer 1. The polyphenylene ether-containing resin layer 1 had a thickness of 300 µm, the adhesion resin layer 3 had a thickness of 20 µm, and the polyvinylidene fluoride-based resin layer 2 had a thickness of 20 µm.

### (Example 4)

A multilayer sheet was prepared in a manner similar to Example 1 described above, except that a polymethyl methacrylate resin (trade name: Sumipex LG2, produced by Sumitomo Chemical Co., Ltd.) was used as the raw material for the adhesion resin layer 3. The polyphenylene ether-containing resin layer 1 had a thickness of 300 µm, the adhesion resin layer 3 had a thickness of 20 µm, and the polyvinylidene fluoride-based resin layer 2 had a thickness of 20 µm.

### (Example 5)

A multilayer sheet was prepared in a manner similar to Example 1 described above, except that a block styrene-ethylene-butylene-styrene copolymer, i.e., a hydrogenation product of a conjugated diene-based copolymer (trade name: Tuftec H1053, produced by Asahi Kasei Chemicals Corp.) was used as the raw material for the adhesion resin layer 3. The polyphenylene ether-containing resin layer 1 had a thickness of 300 µm, the adhesion resin layer 3 had a thickness of 20 µm, and the polyvinylidene fluoride-based resin layer 2 had a thickness of 20 µm.

### (Example 6)

A multilayer sheet was prepared in a manner similar to Example 1 described above, except that a maleic acid-modified block styrene-ethylene-butylene-styrene copolymer, i.e., a hydrogenation product of a maleic acid-modified conjugated diene-based polymer (trade name: Tuftec M1913, produced by Asahi Kasei Chemicals Corp.) was used as the raw material for the adhesion resin layer 3. The polyphenylene ether-containing resin layer 1 had a thickness of 300 µm, the adhesion resin layer 3 had a thickness of 20 µm, and the polyvinylidene fluoride-based resin layer 2 had a thickness of 20 µm.

### (Comparative Example 1)

A multilayer sheet of Comparative Example 1 was prepared by layering a polyvinyl fluoride film, a polyethylene terephthalate (PET) film, and a polyvinyl fluoride film in that order, applying a urethane-based adhesive between the layers, and adhering and integrating the layers under heat and pressure. In the multilayer sheet of Comparative Example 1, the polyvinyl fluoride film had a thickness of 20 µm, the polyethylene terephthalate (PET) film of 300 µm, and the polyvinyl fluoride film of 20 µm.

### (Comparative Example 2)

A polyphenylene ether-containing resin layer 1 and a polyvinylidene fluoride-based resin layer 2 that are prepared by a manner similar to Example 1 were bonded under heat and pressure via a terpene-based hot melt adhesive under the condition of 160°C and 0.1 MPa, to give a multilayer sheet of Comparative Example 2.

### <Preparation of solar cell module>

Solar cell modules were then prepared, respectively using the multilayer sheet of Examples 1 to 6 and Comparative Examples 1 and 2 prepared by the methods described above. Specifically, a glass plate having a thickness of 3 mm, a sealant sheet of an ethylene-vinyl acetate copolymer having a thickness of 400 µm, 4 polycrystalline silicon cells (wired to each other in series), a sealant sheet, and a backsheet (each of the multilayer sheets of Examples 1 to 6 and Comparative Examples 1 and 2) were stacked in that order, and the laminate was pressed and heated for lamination in a vacuum laminater at a pressure of 1 atmospheric pressure, at 135°C for 10 minutes, to give a solar cell module.

### <Evaluation>

The adhesive strength, flame resistance, and moisture transmittance (moisture permeability) of the multilayer sheets of Examples 1 to 6, and Comparative Examples 1 and 2 were examined. In addition, the weather resistance of the solar cell modules of Examples 1 to 6 and Comparative Examples 1 and 2 was examined. Each test item was evaluated by the following test methods.

### (Test methods)

### (1) Determination of the adhesive strength between the layers of multilayer sheet

The peeling strength between the layers of the multilayer sheets of Examples 1 to 6 and Comparative Examples 1 and 2 was determined at room temperature (25°C) and also at 100°C according to the method of "Adhesives - Determination of peel strength of bonded assemblies - Part 3: T-peel test" specified by JIS K6854-3. The shape of the test piece then was a stripe shape of 15 mm in width x 250 mm in length (bonded area) and the peel rate in the peel test was 100 mm/minute.

The peeling strength of the multilayer sheet after storage in an environment at a temperature of 85°C and a humidity of 85% for 1000 hours was also determined. Further, the environmental test was carried out for 3000 hours and the peeling strength after then was also measured.

### (2) Flame resistance

The flame resisting characteristics of the multilayer sheets of Examples 1 to 6 and Comparative Examples 1 and 2 were evaluated by the surface flammability (radiant panel) test according to ASTM E162 to determine its flame spread index.

### (3) Moisture transmittance (moisture permeability)

The moisture permeability of the multilayer sheets of Examples 1 to 6 and Comparative Examples 1 and 2 at 40°C and a relative humidity of 90% was determined according to the "Testing methods for determination of the water vapour transmission rate of moisture-proof packaging materials (dish method)" specified by JIS Z0208.

### (4) Evaluation of the weather resistance of solar cell modules

An environmental test at a temperature of 85°C and a humidity of 85% for 1000 hours was performed according to the high-temperature high-humidity test of JIS C8990 10.13, using each of the solar cell modules of Examples 1 to 6 and Comparative Examples 1 and 2. The maximum power before and after the environmental test was determined, using a solar simulator (PVS1116i, produced by Nisshinbo Mechatronics) and the diminution rate of the maximum power was calculated. Similar measurements were performed after 2000 hours and also after 3000 hours.

The test results above are summarized in the following Table 1.

**[Table 1]**

| | | Example 1 | Example 2 | Example 3 | Example 4 | Example 5 | Example 6 | Comparative Example 1 | Comparative Example 2 |
|---|---|---|---|---|---|---|---|---|---|
| Polyphenylene ether-containing resin layer | | PPE/SEBS =80/20 (part) | PPE/SEBS =20/80(part) | PPE/GPPS =40/60(part) | PPE/SEBS =80/20(part) | PPE/SEBS =80/20(part) | PPE/SEBS =80/20(part) | PVF film, PET film, and PVF film laminated with urethane-based adhesive in that order | PPE-containing resin layer and PVDF-based resin layer of Example 1 laminated with terpene-based hot melt adhesive |
| Polyvinylidene fluoride resin layer | | PVDF/PMMA/ white inorganic pigment =80/20/20 (part) | PVDF/PMMA/ white inorganic pigment= 80/20/20(part) | PVDF/PMMA/ white inorganic pigment=80/20/ 20(part) | PVDF/PMMA/ white inorganic pigment=80/20/ 20(part) | PVDF/PMMA/ white inorganic pigment=80/20/ 20(part) | PVDF/PMMA/ white inorganic pigment=80/20/ 20(part) | | |
| Adhesion resin layer | | Urethane- modified SEP | Urethane- modified SEP | Urethane- modified SEP | PMMA | SEBS | Maleic acid-modified SEBS | | |
| Initial peeling strength of multilayer sheet, room temperature (N/width 15 mm) | | >10 Breakage of material | >10 Breakage of material | >10 Breakage of material | >10 Breakage of material | >10 Breakage of material | >10 Breakage of material | >10 Breakage of material | >10 Breakage of material |
| Initial peeling strength of multilayer sheet, 100°C (N/width 15 mm) | | >10 Breakage of material | >10 Breakage of material | >10 Breakage of material | >10 Breakage of material | >10 Breakage of material | >10 Breakage of material | >10 Breakage of material | 2. 1 |
| Peeling strength after environmental test | 1000 hours | >10 Breakage of material | >10 Breakage of material | >10 Breakage of material | >10 Breakage of material | >10 Breakage of material | >10 Breakage of material | 6 | - |
| | 3000 hours | >10 Breakage of material | >10 Breakage of material | >10 Breakage of material | >10 Breakage of material | >10 Breakage of material | >10 Breakage of material | 2 Deterioration of sheet strength | - |
| Flame spread index (Is), as determined by surface flammability (radiant panel) test | | 0.8 | 5. 7 | 2.0 | 0.9 | 0.8 | 0.8 | 43 | 10 |
| Moisture permeability of multilayer sheet (g/m²·24 hours) | | 1.2 | 1.7 | 1.2 | 1.3 | 1.2 | 1.2 | 1.7 | 1.2 |
| Initial maximum power of module (W) | | 14.7 | 14.5 | 14.5 | 14.5 | 14.6 | 14. 6 | 14.7 | 14.6 |
| Deterioration rate of maximum power between before and after environmental test (%) | 1000 hours | 0.0 | 0.0 | 0.1 | 0.1 | 0.0 | 0.0 | 0.5 | 5. 9 |
| | 2000 hours | 0.1 | 0.1 | 0.1 | 0.1 | 0.2 | 0.2 | 0.5 | 20 |
| | 3000 hours | 1.5 | 1.5 | 2.0 | 2.0 | 1.9 | 1.7 | 4.5 | 55 |

The peeling strength of the multilayer sheets of Examples 1 to 6 and Comparative Examples 1 and 2 respectively at room temperature and 100°C was determined, showing that the multilayer sheets of Examples 1 to 6 were broken (breakage of material) under a load of more than 10N/15 mm and had high adhesive strength. On the other hand, the multilayer sheet of Comparative Example 2 had very small peeling strength at 100°C.

The peeling strength of the multilayer sheets of Examples 1 to 6 and Comparative Examples 1 and 2 after environmental tests (after storage in an environment at a temperature of 85°C and a humidity of 85% for 1000 hours and 3000 hours) was determined, showing that the multilayer sheets of Examples 1 to 6 had high adhesive strength similarly to test of the initial peeling strength.

On the other hand, the multilayer sheet of Comparative Example 1 showed deterioration in peeling strength and also in appearance and strength of the polyethylene terephthalate (PET) film. It is probably because the polyethylene terephthalate (PET) film was degraded by hydrolysis under the high temperature high-humidity environment. Alternatively, the multilayer sheet of Comparative Example 2 was exfoliated during storage, and the peeling strength thereof could not be determined after the environmental tests.

Further, the diminution rate of the maximum power between before and after the environmental test of the solar cell modules of Examples 1 to 6 and Comparative Examples 1 and 2 was examined, showing that the solar cell modules of Examples 1 to 6 had smaller diminution rate of the maximum power.

On the other hand, the backsheet was exfoliated in the solar cell modules of Comparative Examples 1 and 2, leading to enhanced degradation of the solar cells. In particular, the solar cell module of Comparative Example 2 had a very large diminution rate of the maximum power of more than 50% after an environmental test at a temperature of 85°C and a humidity of 85% for 3000 hours. None of the solar cell modules of Examples 1 to 6 showed such a phenomenon.

The flame resistance of the multilayer sheets of Examples 1 to 6 and Comparative Examples 1 and 2 was examined, showing that the solar cell modules of Examples 1 to 6 had favorable flame resistance. For example, the solar cell modules of Examples 1 to 6 are considered to be at a level at which the hazard of fire or spread of fire caused by sparkover due to insufficient insulation of output terminals or by flashing from outside can be avoided, but those of Comparative Examples 1 and 2 were found to be inferior in this point.

As described above, the multilayer sheets of Examples 1 to 6, which were prepared within the scope of the present invention, were superior in the adhesiveness between layers and retained their peel strengths even under high-temperature high-humidity environment. In addition, the solar cell modules prepared by using such a multilayer sheet as the back sheet showed smaller diminution rates of maximum power when stored under high-temperature high-humidity environment. As obvious from the results above, the multilayer sheets were superior in weather resistance, heat resistance, and moisture proofness, and these properties and also the adhesiveness between the layers were preserved under high-temperature high-humidity environment, and it is apparently for this reason that water penetration into the solar cell modules was suppressed and the properties of the solar cells were favorably preserved. In addition, all of the multilayer sheets obtained in Examples 1 to 6 showed favorable flame resisting properties and are considered to be at a level at which the hazard of fire or spread of fire caused by sparkover due to insufficient insulation of output terminals or by flashing from outside, for example in solar cell module, can be avoided.

The results above confirm that it is possible according to the present invention to provide cost-effectively a multilayer sheet that is favorable in weather resistance, heat resistance, moisture resistance, and interlayer adhesion, superior in flame resisting properties, and suitable as a backsheet for solar cells.

### Reference Signs List

- 1:: Polyphenylene ether-containing resin layer
- 2:: Polyvinylidene fluoride-based resin layer
- 3:: Adhesion resin layer
- 10:: Multilayer sheet
- 11:: Solar cell module
- 12:: Transparent substrate
- 13:: Sealing material
- 14:: Frame
- 15:: Solar cell
- 16:: Sunlight

## Claims

1. A multilayer sheet comprising:
a first resin layer of a polyphenylene ether-containing resin composition;
a second resin layer of a polyvinylidene fluoride-based resin composition; and
an adhesion resin layer, which is placed between the first and second resin layers, of one or more resins selected from acrylic resins and polymers having a structural unit derived from conjugated diene; wherein
the adhesion resin layer is fused both to the first and second resin layers.

2. The multilayer sheet according to Claim 1, wherein
the adhesion resin layer contains the polymer having a structural unit derived from conjugated diene and
the polymer having a structural unit derived from conjugated diene is one or more resins selected from conjugated diene-based polymers, the hydrogenation products thereof, or the urethane- or maleic acid-modified products of the hydrogenation products, and copolymers of a conjugated diene having 4 to 8 carbon atoms with aromatic vinyl compounds, the hydrogenation products thereof, or the urethane- or maleic acid-modified products of the hydrogenation products.

3. The multilayer sheet according to Claim 1 or 2, wherein the resin composition constituting the first resin layer contains polyphenylene ether in an amount of 20 to 80 mass %.

4. The multilayer sheet according to any one of Claims 1 to 3, wherein the resin composition constituting the first resin layer contains one or more resins selected from homopolymers of a conjugated diene having 4 to 8 carbon atoms, copolymers of a conjugated diene having 4 to 8 carbon atoms with other monomers or the hydrogenation products thereof, copolymers of a conjugated diene having 4 to 8 carbon atoms with aromatic vinyl compounds or the hydrogenation products thereof, homopolymers of an olefinic hydrocarbon having 2 to 20 carbon atoms or the copolymers thereof, copolymers of an olefinic hydrocarbon having 2 to 20 carbon atoms with other monomers, and polystyrenes, in an amount of 80 mass % or less.

5. The multilayer sheet according to any one of Claims 1 to 4, wherein the polyvinylidene fluoride-based resin composition constituting the second resin layer contains a white inorganic pigment in an amount of 1 to 40 parts by mass with respect to 100 parts by mass of a resin component consisting of polyvinylidene fluoride: 50 to 99 mass % and polymethyl methacrylate: 1 to 50 mass %.

6. The multilayer sheet according to any one of Claims 1 to 5, wherein the first resin layer has a thickness of 50 to 500 µm and the second resin layer and the adhesion resin layer have a thickness of 5 to 50 µm.

7. The multilayer sheet according to any one of Claims 1 to 6, wherein the resin composition constituting the first resin layer contains a flame retardant and/or a weather-resistance improver added thereto.

8. The multilayer sheet according to any one of Claims 1 to 7, wherein
the first and second resin layers have a melt flow rate at 230°C under a load of 2.16 kg, as determined by Method A specified by JIS K7210, of 0.5 to 25 g/10 minutes and
the adhesion resin layer has a melt flow rate at 230°C under a load of 2.16 kg, as determined by Method A specified by JIS K7210, of 0.1 to 50 g/10 minutes.

9. The multilayer sheet according to any one of Claims 1 to 8, wherein the first resin layer, the second resin layer, and the adhesion resin layer are laminated by coextrusion method.

10. The multilayer sheet according to any one of Claims 1 to 9, wherein the first resin layer, the second resin layer, and the adhesion resin layer are formed by melt coextrusion molding in a temperature range of 130 to 260°C.

11. The multilayer sheet according to any one of Claims 1 to 10, further comprising:
a third resin layer containing an ethylene vinyl acetate copolymer as resin component, as laminated at least on the first resin layer.

12. A backsheet for solar cells, comprising the multilayer sheet according to any one of Claims 1 to 11.

13. A solar cell module, comprising the backsheet according to Claim 12.
